Europäisches Patentamt

(19) European Patent Office

Office européen des brevets

(11) Publication number: **0 191 434 B1**

(12) **EUROPEAN PATENT SPECIFICATION**

(45) Date of publication of patent specification :
16.01.91 Bulletin 91/03

(51) Int. Cl.⁵ : **H01L 21/60**

(21) Application number : 86101606.1

(22) Date of filing : 07.02.86

(54) Improved solder connection between microelectronic chip and substrate and method of manufacture.

(30) Priority : 15.02.85 US 702199
15.02.85 US 702296

(43) Date of publication of application :
20.08.86 Bulletin 86/34

(45) Publication of the grant of the patent :
16.01.91 Bulletin 91/03

(84) Designated Contracting States :
DE FR GB

(56) References cited :
FR-A- 2 541 044
US-A- 3 429 040
US-A- 4 081 901
IBM TECHNICAL DISCLOSURE BULLETIN,
vol. 25, no. 4, September 1982, pages
1952-1953, New York, US; J.C. EDWARDS:
"Photo-defined lamination for chip bonding"
IBM TECHNICAL DISCLOSURE BULLETIN,
vol. 16, no. 11, April 1974, pages 3610-3611,
New York, US; L.S. GOLDMANN et al.:
"Lead-Indium for joining a semiconductor
chip to a substrate"
IBM TECHNICAL DISCLOSURE BULLETIN,
vol. 18, no. 10, March 1976, page 3477, New
York, US; L. KUHN et al.: "High-density,
low-temperature solder reflow bonding of
silicon chips to plastic substrates"

(72) Inventor : Blakeslee, Marybelle C.
152 So. Holman Way
Golden Colorado 80401 (US)
Inventor : Chance, Dudley Augustus
21 Deepwood Drive
Danbury, Ct. 06810 (US)
Inventor : Eastman, Dean Eric
806 Pinesbridge Road
Ossining New York 10562 (US)
Inventor : Gniewek, John J.
6025 Wendrew
Tucson Arizona 85711 (US)
Inventor : Ho, Chung Wen
17334 Parkside Ct
Monte Sereno, Ca 95030 (US)
Inventor : Levine, Ernest N.
30 High Acres Drive
Poughkeepsie, NY 12603 (US)
Inventor : Ordonez, Jose E.
RD No 1, Rombout Road
Pleasant Valley New York 12569 (US)
Inventor : Reiley, Timothy Clark
140 Bennetts Farm Road
Ridgefield, CT 06877 (US)
Inventor : Skarvinko, Eugene R.
4 Giles Street
Binghamton New York 13905 (US)

(74) Representative : Moss, Robert Douglas
IBM United Kingdom Limited Intellectual
Property Department Hursley Park
Winchester Hampshire SO21 2JN (GB)

(73) Proprietor : International Business Machines
Corporation
Old Orchard Road
Armonk, N.Y. 10504 (US)

## Description

Technical Field

The present invention concerns electrical connections between microelectronic chips and their supporting substrates. More particularly, the invention concerns an improved solder connection and a method of manufacturing such a connection, the improved connection being configured such that larger microelectronic chips with denser matrices of solder connections can be used, without exceeding acceptable shear stress limits during heat-up and cool-down cycles during operation of the microelectronic chip.

Background Art

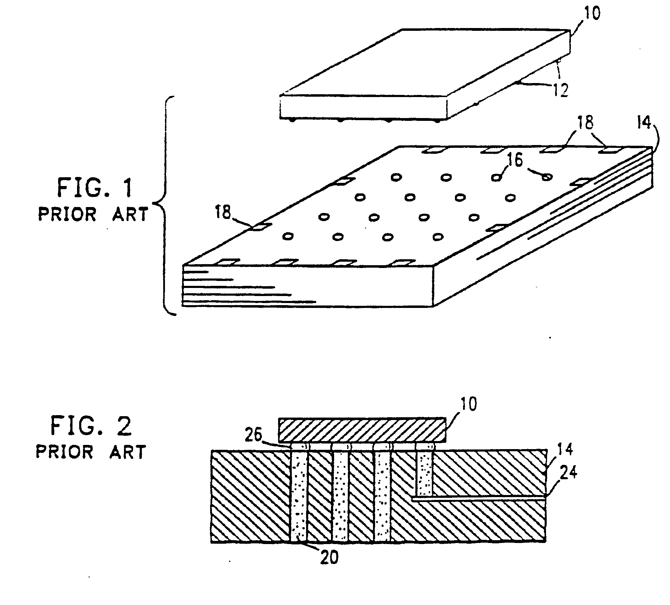

During the past two decades the extraordinarily rapid development of techniques for producing integrated circuit devices has made it possible to provide on a single silicon ship extremely complex circuits comprising very large numbers of individual circuit elements. Such chips typically are approximately 6.5 mm square so that the connection points or solder pads which electrically connect the chips to the outside world to receive and transmit data and to receive operating power are necessarily extremely small. Figure 1 shows an exploded, perspective view and Figure 2 shows a fragmentary sectional view of one prior art technique commonly used for mounting a chip 10 to an underlying support. Usually, the silicon chip is provided with microelectronic circuitry on only one side. To connect the chip to the outside world, conductive paths are provided through the thickness of the chip to its underside where a matrix of downwardly projecting solder balls 12 is provided in the now familiar manner. Such tiny solder balls provide controlled collapse connections for chip 10 and are commonly referred to in the art as C-4 connections. The C-4 solder balls are placed in contact with a support or substrate 14 having a corresponding matrix of solder connection pads 16 which are essentially flush with its upper surface.

Substrate 14 may be a multi-layered ceramic structure of the type described in US-A-4,245,273 granted to Feinberg and Landon for "Package for Mounting and Interconnecting a Plurality of Large Scale Integrated Semiconductor Devices". Such a substrate may include peripheral connection pads 18, input/output and power pads (not illustrated) on its lower face and vertically and transversely extending conductive paths 20,24 extending through the body of substrate 14 to interconnect chip 10 and connector pads 16 to various input/output and power sources, as desired. Another example of such a substrate may be found also in IBM Technical Disclosure Bulletin, Vol. 24, no. 11A, April 1982, 5554by E. Hubacher for "Shared EC Pad Design".

To join chip 10 to substrate 14, the solder balls 12 are placed in contact with connection pads 16, the ambient temperature is raised to the fusion temperature of the solder and the solder then reflows to produce the type of short connection column 26 illustrated in Figure 2. Such prior art connection columns typically are 0.025 to 0.050 mm in length or about half the diameter of the solder ball used. As used in this description, the term "solder" means a metallic alloy having a fusing temperature in the range of 200 to 320 degrees Celsius, the major metal components of the alloy being lead (40-95%), and tin (5-60%).

While C-4 solder joints have been used extensively to connect silicon devices to underlying substrates in the manner shown in Figures 1 and 2, application of this type of joint has been limited to smaller sized chips requiring only a limited number of connections to a substrate. Such limitations arise due to shear strain which develops in the C-4 joints due to differential thermal expansion between substrate 14 and chip 10. The difference between the expansion of the chip and the substrate between room temperature and operating temperature must be accommodated by deformation of columns 26. The extent of the allowable deformation is governed by the desired fatigue cycle life for the joint. The maximum shear displacement of a joint, $\delta$, is given by the following expression :

$$\delta = \frac{(\sqrt{2}\ L)}{2}\ (-\alpha_c + \alpha_b)\ \Delta T,$$

where L is the longest dimension along any edge of the matrix of C-4 connections, $\alpha_c$ and $\alpha_b$ are the coefficients of thermal expansion for the silicon device and the substrate ; $\Delta T$ is the temperature rise from room temperature to operating temperature. For some time, it has been recognised that as the height h of columns 26 increases, the shear strain $\gamma$ decreases in accordance with the following relationship :

$$\gamma = \frac{\delta}{h},$$

where $\delta$ is the shear displacement for the column in question.

Successful performance of a C-4 joint is determined by reference to the maximum shear strain which the outermost C-4 joint would experience during operation of a given combination of chip and substrate. So, for a given maximum allowable shear strain, an increase in the C-4 joint height h will allow a proportionate increase in the overall size of the matrix of C-4 joints and a concomitant increase in the permissible size of the silicon device itself. Since a larger chip allows a greater degree of integration, with more functions performed on the chip, an improvement in speed and efficiency of production can be obtained.

Examples of prior art attempts to increase the length of the connection between a chip and its substrate are disclosed in US-A-3,719,981 granted to Steitz for "Method of Joining Solder Balls to Solder Bumps", US-A-3,591,839 granted to Evans for "Microelectronic Circuit with Novel Hermetic Sealing Structure and Method of Manufacture" and in US-A-4,067,104 granted to Tracy for "Method of Fabricating an Array of Flexible Metallic Interconnects for Coupling Microelectronics Components". However, merely increasing the height of the C-4 connector can introduce additional problems which may offset any advantage of being able to use a larger chip. For example, there is an increased tendency for electrical shorting between the closely spaced C-4 connectors, as the connectors deflect during thermal cycling. Thus, a need has developed for means to constrain the C-4 connectors from spreading into contact with each other when very small spacing between connectors is desired.

## Summary of the Invention

Accordingly, the present invention provides a method for providing controlled collapse connections between a microelectronic chip having a surface including a matrix of electrical connection points and a support substrate having a surface including a corresponding matrix of electrical connection points, the method comprising the steps of forming, at at least a portion of the connection points on at least one of said surfaces, of an electrically insulating material, dam means defining a central open volume around each such connection point, introducing molten solder into each open volume defined by the dam means, allowing the solder to cool to form, at each of the connection points concerned, a solder column, positioning the chip and the substrate such that the respective matrices of connection points are in alignment, and heating the assembly thus formed to melt the solder columns and form said controlled collapse connections, the material of the dam means being such that, on subsequent cooling, the dam means and solder columns separate at least partially from each other so as to permit flexing of the solder columns.

This method allows C-4 connections to be made at greater density and over a greater area than previously possible by enabling longer solder columns which have some freedom to flex to be successfully implemented without danger of shorting.

A preferred feature of the invention is that the step of forming the dam means comprises providing a layer of electrically insulating material on the respective surface, and providing through the layer a plurality of holes corresponding to the connection points on each surface to be dammed, to thereby define the central open volume at each such connection point.

In one preferred method according to the invention the coefficient of thermal expansion of the damming material is about one fourth that of the solder. This facilitates separation of the dam from the solder column on cooling. In this case, it is additionally preferred that the layer of electrically insulating material is ceramic, the layer preferably having a thickness in the range 0.025 to 0.127 millimetres.

Alternatively, according to another preferred variant of a method according to the invention, the coefficient of thermal expansion of the damming material may be substantially greater than that of the substrate or chip or both to which it is applied and the damming material may preferably be a polyimide material.

In this alternative implementation of the invention, the thickness of the damming layer is preferably in the range 0.050 to 0.200 millimetres and the dam means and solder columns are preferably formed on the substrate. In one preferred variant of this implementation, the dam means are further defined by removing sections of the electrically insulating layer to leave an annular solder dam surrounding each said open volume.

## Brief Description of the Drawings

The invention will now be described, by way of example only with reference to the following drawings in which :

Figure 1 shows an exploded, perspective view of a prior art microelectronic chip and substrate prior to joining.

Figure 2 shows a fragmentary sectional view of a prior art joint between a substrate and a microelectronic chip.

Figure 3 shows a fragmentary sectional view of an improved C-4 solder joint according to the present invention in which damming means are provided on the underside of the chip.

Figure 4 shows a fragmentary sectional view of a specific application of the generic invention in which annular damming means are provided on the upper surface of the substrate.

Figure 5 shows a fragmentary sectional view of the structure illustrated in Figure 4 following deformation of the joints due to differential thermal expansion.

Figure 6 shows a fragmentary sectional view through a further specific application of the generic invention in which the damming means are provided by a layer of electrically insulating material on the upper surface of the substrate.

Figures 7 and 8 show fragmentary sectional views of a portion of the structure illustrated in Figure 6 and indicate how the holes through the layer of electrically insulating material deform due to differential thermal expansion and contraction.

Figure 9 shows a fragmentary sectional view of the specific application of Figure 6, illustrating how the walls of the damming means are spaced from the solder joints to allow for distortion of the joints due to differential thermal expansion during operation.

Figures 10 to 15 show fragmentary sectional views of the embodiment of Figure 6 illustrating the different distortions of the solder joints produced at the edge of the chip and at the centre of the chip at reflow, room and operating temperature.

Figure 16 shows a fragmentary sectional view of yet another specific application of the invention in which the damming means are formed on a multi-layered ceramic substrate by providing the final layer of ceramic with appropriate apertures for receiving solder.

Figures 17 to 21 illustrate the sequential steps for preparing a substrate of the type illustrated in Figure 16.

Figure 22 shows a variation of the specific application illustrated in Figure 16 in which damming means are provided on both the substrate and the chip.

Detailed Description of the Invention

The following is a detailed description of the preferred embodiment of the invention, reference being made to the drawings in which the same reference numerals identify the same elements of structure in each of the several Figures.

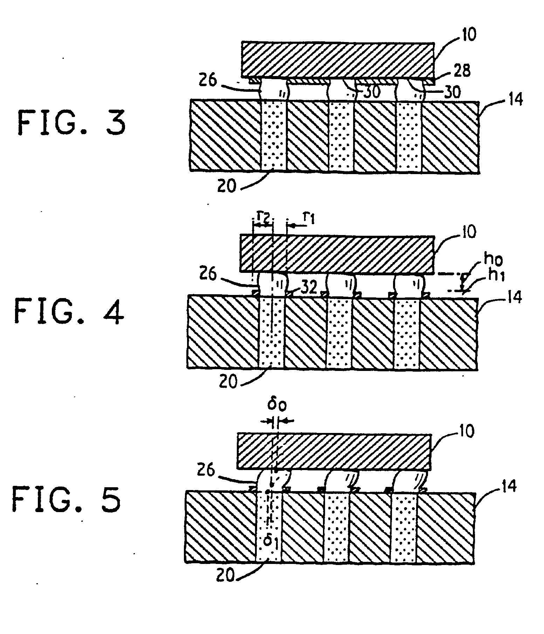

In the embodiment shown in Figure 3, the underside of chip 10 has been provided with a layer 28 of photo-sensitive polyimide or photo-sensitive di-electric epoxy, the layer having a thickness about 0.050 to 0.200 mm. Then, via holes 30 are opened through layer 28 using photo-lithographic techniques. Solder balls are then deposited within the vias 30 to provide solder balls or columns having a longer axial dimension than known in the prior art. The increase in the height of the solder balls, of course, is possible due to the presence of additional solder in vias 30. When a chip formed in this manner is joined to a substrate 14, as illustrated in Figure 3, a longer joint 26 results so that larger chips having more densely packed C-4 joints can be used. Also, layer 28 functions as a means for at least partially damming the flow of solder during reflow to join chip 10 to substrate 14, thereby lessening the possibility of solder spread which would cause short circuits.

Figures 4 and 5 show a specific application of the generic invention in which electrically insulating, readily deformable rings 32 are provided around each connector pad 16 of substrate 14. Conventional photolithographic techniques can be used to define rings 32 from a layer of a suitable material such as polyimide, after which the open central volume of the rings can be filled with solder by dipping or wave soldering techniques familiar to those skilled in the art. Thus, the rings act as solder dams in the manner previously described.

As the chip 10 shown in Figure 4 is cycled between its operating temperature and room temperature, joints 26 and rings 32 are deformed, the former plastically and the latter elastically. For a polyimide ring height $h_1$ of about 0.064 mm, an inner radius $r_1$ of about 0.057 mm and an outer radius $r_2$ of about 0.079 mm, it can be shown that the shear strain in the unsupported portion of joints 26 between rings 32 and the underside of chip 10, is reduced by approximately 25%. For this situation, a ring 32 of about 0.020 mm radial thickness allows the lower portion of joint 26 to deform slightly, as shown in Figure 5. For thicker rings, smaller changes would be observed in the imposed shear strain. With this technique, an improvement in the C-4 joint allows an increase in chip size of approximately 25% without exceeding maximum shear strength constraints.

An improvement of this magnitude can be achieved with the embodiment shown in Figures 4 and 5, as shown in the following brief analysis. A balance of the shear forces at the top of each ring 32 requires that

$$\tau_0 \pi r_1^2 = \tau_1 \pi r_1^2 + \tau_p \pi ( r_2^2 - r_1^2 ) \qquad \ldots (1),$$

where $\tau_0$ is the shear stress in the unsupported part of the C-4 column, assumed constant ; $r_1$ is the radius of the C-4 column ; $\tau_1$ is the shear stress in the solder within ring 32, assumed constant ; $\tau_p$ is the shear stress in ring 32, assumed constant ; and $r_2$ is the outer radius of ring 32.

Since the polyimide may be treated as entirely elastic,

$$\tau_p = \mu_p \cdot \frac{\delta_1}{h_1} \qquad \ldots (2),$$

where $\mu_p$ is the shear modulus of the polyimide ; $\delta_1$ is the displacement of the top of ring 32 ; and $h_1$ is the height of ring 32.

Since the shear strains of interest within the joints 26 are approximately 1%, the solder material can be considered to be a work-hardening, plastically deforming material so that,

$$\tau = A + B\gamma^n \qquad \ldots (3),$$

where A, B and n are constants and $\gamma$ is the shear strain. Based on the information presented in IBM Technical Disclosure Report, TR 22.1009 (1970) by H.S. Rathore, R.C. Yih and A.R. Edenfeld for "Mechanical Properties of 5/95Sn/Pb Solder and Solder Containing Impurities", rough estimates of A, B and n are 3 x $10^6$ N/m$^2$, 8.5 x $10^6$ N/m$^2$ and about 0.5, respectively, for strains of approximately 1%.

Combining equations (1), (2) and (3) yields :

$$A + B \left[ \frac{\delta_0}{h_0} \right]^{\frac{1}{2}} = A + B \left[ \frac{\delta_1}{h_1} \right]^{\frac{1}{2}} + \mu p \left[ \frac{\delta_1}{h_1} \right] \cdot \left[ \frac{r_2^2}{r_1^2} - 1 \right]$$

from which

$$\left[ \frac{\delta_0}{h_0} \right]^{\frac{1}{2}} = \left[ \frac{\delta_1}{h_1} \right]^{\frac{1}{2}} + \left[ \frac{\mu_p}{B} \right] \cdot \left[ \frac{\delta_1}{h_1} \right] \cdot \left[ \frac{r_2^2}{r_1^2} - 1 \right] \qquad \ldots (4),$$

where $\delta_0$ equals the displacement accommodated by the section of the solder column above the ring 32.

Letting $h_0$ equal $h_1$ and noting that $\delta$ (the total displacement accommodated by the solder column) equals $\delta_1$ plus $\delta_0$ then

$$(\delta - \delta_1)^{\frac{1}{2}} = \delta_1^{\frac{1}{2}} + \frac{\mu_p}{Bh_1^{\frac{1}{2}}} \cdot \delta_1 \left[ \frac{r_2^2}{r_1^2} - 1 \right] \qquad \ldots (5),$$

The values of $\delta_0$ and $\delta_1$ are shown below for several values of $r_2$ where $r_1$ is 0.057 mm ; $h_1$ equals $h_0$ equals 0.064 mm ; $\mu_p$ equals 18.1 x $10^6$ N/m$^2$ ; B equals 8.5 x $10^6$ N/m$^2$ and $\delta$ equals 61.9 x $10^{-5}$ mm, a typical maximum displacement for chips currently in use.

| $r_2$ (mm) | $\delta_0$ (mm) | $\delta_1$ (mm) | $\delta_0/\delta$ |
|---|---|---|---|
| 0.079 | $48.3 \times 10^{-5}$ | $13.7 \times 10^{-5}$ | 0.78 |
| 0.095 | $53.1 \times 10^{-5}$ | $9.14 \times 10^{-5}$ | 0.86 |
| 0.122 | $56.6 \times 10^{-5}$ | $5.33 \times 10^{-5}$ | 0.91 |

Note that $r_2$ greater than 0.114 mm is not meaningful for any array of connector pads having a centre-to-centre spacing of 0.228 mm ; however, this example may be used as an indication of the stiffness of a solid polyimide layer having cylindrical holes spaced 0.114 mm apart.

The value of $\delta_0/\delta$ provides a measure of the shear strain reduction in the upper, unsupported portion of each joint 26 with respect to a standard joint 26 of the type shown in Figure 2 and not supported by a ring 32. For the thinnest polyimide ring having a wall thickness of 0.020 mm, a reduction in shear strength of about 22% would be expected. If the chip size were increased such that the standard, acceptable maximum shear strain were imposed, the length and width of the matrix of connectors would each be approximately 25% greater than the original.

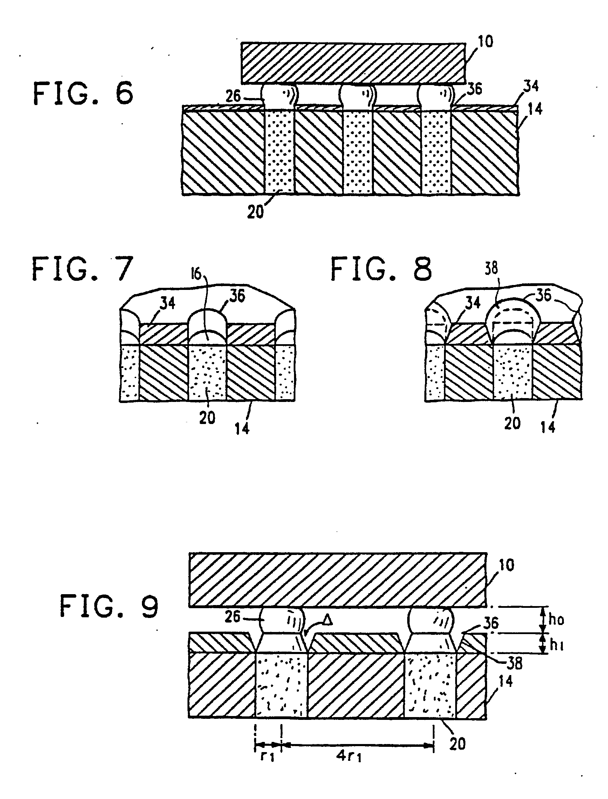

Figures 6 to 15 illustrate a further specific application of the generic invention in which a solder damming means is provided which typically separates from the solder column at operating temperature, thereby giving a greater freedom of movement to the lower part of the solder column and a more effective reduction in shear strain. A layer 34 of electrically insulating material having a high coefficient of thermal expansion relative to that of substrate 14 is provided on the upper surface of substrate 14. For example, a layer of polyimide plastic having a thickness in the range of 0.050 to 0.200 mm may be provided. Such a polyimide plastic has a coefficient of thermal expansion $\alpha_p$ of approximately $25 \times 10^{-6}$/degree K, whereas, the coefficient of expansion of the substrate $\alpha_b$ is approximately $6.5 \times 10^{-6}$/degree K, where 92% $Al_2O_3$ ceramic is used for substrate 14. Where such a layer 34 is provided with an array of vertical, cylindrical vias 36 as shown in Figures 6 and 7, the top of each via 36 will open with respect to the bottom of the via as substrate 14 and the adhered layer 34 drop in temperature from a temperature appropriate for solder joining. See Figure 8. This occurs due to bi-axial tensile stresses in the upper layer, assuming good adhesion between layer 34 and substrate 14.

When a substrate having such a layer 34 is joined to a chip 10 in the manner illustrated in Figure 9, a gap exists at room temperature between the solder joint 26 and the inside wall 38 of each via 36. Furthermore, the metal solder will shrink more than the substrate, causing an even larger gap to be formed. The coefficient of thermal expansion of a solder comprising lead and 5% tin is approximately $25 \times 10^{-6}$/degree K. Thus, the polyimide wall 38 and the solder will move away from each other.

The structure shown in Figures 6 to 9 is formed by applying to the upper surface of substrate 14 a layer of electrically insulating material having a high coefficient of thermal expansion. In this layer, holes are created having the dimension of the desired C-4 connections and extending from the top of the layer to the underlying solder pad 16,20 with which the C-4 connection will be in electrical contact. These holes thus function as solder dams in the manner previously described. The holes are then filled with molten solder by evaporation, dipping, wave soldering or other known techniques, after which the silicon device, also provided with its own conventional C-4 solder balls, is placed on the substrate and the solder is reflowed to produce the structure shown in Figure 9 after cooling to room temperature.

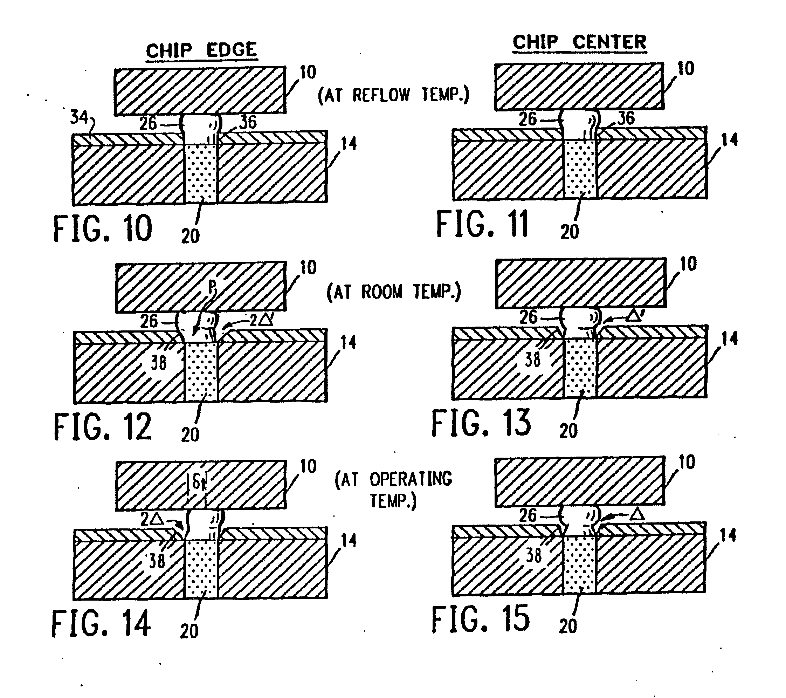

Upon cooling from reflow temperature, the silicon of chip 10 will contract less than the ceramic material of substrate 14 so that solder joints 26 are distorted to the extreme positions illustrated in Figures 10 to 15. As the chip warms up to its operating temperature, the extreme position solder joints, that is those at the periphery of the chip, will be deformed away from the side of vias 36 against which they rested at room temperature. The distance which a point P on the C-4 column at the level of the upper surface of layer 34, moves before the C-4 column impinges on the opposite side of via 36 is $2 \Delta'$ or roughly twice the value $\Delta'$ which would be estimated for columns 26 at the centre of the chip by considering the relaxation of the top of via 36 plus the shrinkage of C-4 column.

Since the polyimide material for layer 34 is stiff with respect to a plastically deforming solder material, it is necessary to avoid the situation in which the C-4 column deforms into contact with the wall of vias 36. Essentially, when a C-4 column comes into contact with the wall of the via, further displacement of chip 10 with respect to substrate 14 will have to be accommodated by deformation of the portion of the C-4 column above layer 34, the solder dam. For a polyimide layer 34 with an array of vias 36 having a radius of 0.057 mm and a centre-to-centre spacing of 0.228 mm and for lead –5% tin solder having a solidification temperature of about 300 degrees Celsius, it is estimated, based on first order approximations, that an increase in chip size of the order of 140% can be achieved without exceeding the maximum shear strain allowable and without having any C-4 column contact the side wall of its via 36.

In view of the isolation of the C-4 columns provided by the solder dams and the significant shear strains achievable without any C-4 column impinging on its solder dam, it is also possible in accordance with the invention to decrease the size and spacing of the C-4 joints. Smaller, more closely spaced holes are easily formed in layer 34. The solder balls on the chip 10 would be made smaller as the C-4 joints are brought closer together. For a typical chip now in use, a polyimide dam 0.050 mm in diameter would allow a C-4 radius of 0.025 mm and centre-to-centre spacing of 0.100 mm, for $h_0$ of about 0.025 mm. This would be a decrease in C-4 joint size and spacing of about 60%.

At the chip operating temperature $T_0$, the gap between the walls of vias 36 and the C-4 columns in an undistorted joint of the type shown in Figure 9 can be estimated as :

$$\Delta = (\alpha_p - \alpha_b) (T_s - T_0) r_1 + (\alpha_s - \alpha_b)(T_s - T_0) r_1$$

$$+ \frac{\Delta V_s}{V} \cdot \frac{1}{3} \cdot r_1 \qquad \ldots (6),$$

where $\alpha_p$ is the thermal coefficient expansion for polyimide ; $\alpha_b$ is the thermal coefficient of expansion for the material of substrate 14 ; $\alpha_s$ is thermal coefficient of expansion for solder ; $T_s$ is the temperature for solder reflow ; $r_1$ is the radius at the bottom of via 36 as seen in Figure 9 and $\Delta V_s/V$ is the volume contraction of the solder upon solidification. This relationship assumes that the spacing between the centres of adjacent connectors is $4r_1$ and that the thermal strains are completely relaxed at the upper surface of layer 34, as would be approximately the case for a structure where $h_1$, the thickness of layer 34, is approximately equal to $r_1$. If $\alpha_p$ equals $\alpha_s$ equals 25 x $10^{-6}$/degree K ; $T_s$ equals 297 degrees Celsius ; $T_0$ equals 85 degrees Celsius ; and $r_1$ equals 0.057 mm, then $\Delta$ equals 46 x $10^{-5}$mm.

The difference in thermal coefficients of expansion between chip 10 and substrate 14 is calculated to lead to a distortion of a C-4 column at the chip edge approximately as illustrated in Figure 12 where the C-4 column is shown pushed against one side of via 36. The distance at room temperature through which such a C-4 column must move to reach the other side of via 36 is defined by :

$$2\Delta' = 2\Delta \left[ \frac{T_s - T_R}{T_s - T_0} \right] \qquad \ldots (7),$$

At the chip operating temperature $T_0$, the distance through which the C-4 column must move is $2\Delta$, as shown in Figure 14. Thus, the imposed displacement $\delta$ arising from the chip/substrate expansion mismatch at $T_0$ must not be so large that the C-4 column contacts the opposite side wall 38 of via 36. This situation may be expressed by the relationship :

$$2\Delta \geq \delta \left[ \frac{h_1}{h_1 + h_0} \right] \qquad \ldots (8),$$

where $\delta$ is given by:

$$\delta = \frac{\sqrt{2}}{2} L (\alpha_b - \alpha_c) (T_0 - T_R) \qquad \ldots (9),$$

where $\alpha_c$ is the coefficient of thermal expansion for chip 10. Since the displacement must not lead to a shear strain exceeding $\gamma_m$, the maximum allowable shear strain of approximately 1%, then :

7

$$\frac{\delta}{h_1 + h_0} \leq \gamma_m \qquad \ldots (10),$$

Then the value of L, the longest dimension along any edge of the matrix of C-4 columns may be maximised by letting :

$$2\Delta = \gamma_m h_1 \qquad \ldots (11),$$

which results in a value of $h_1$ of 0.267 mm. For this value of $h_1$, the resulting value of L is 18.3 mm, which represents an increase of approximately 350% over the currently accepted maximum chip size.

However, using this full solder dam thickness of 0.267 mm would require a large aspect ratio for the via holes. If, as would be reasonable, a one-to-one aspect ratio were used for the via holes, the dam thickness would be 0.125 mm and the increase in allowable C-4 matrix size would be about 140%.

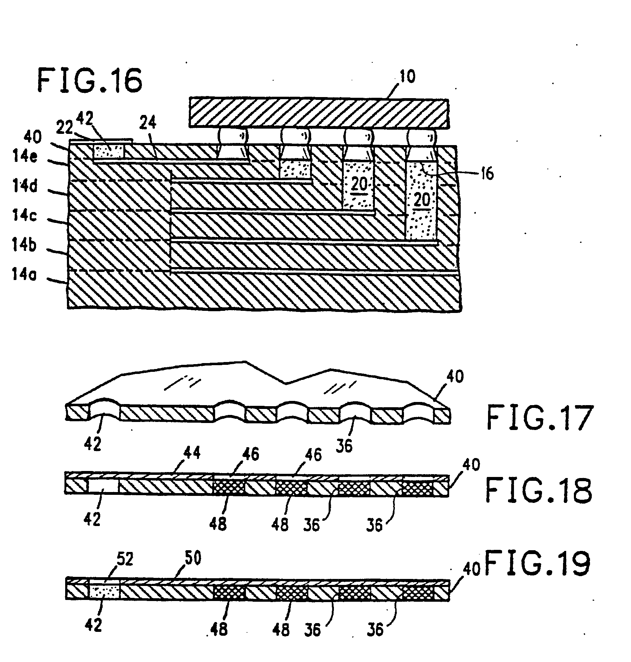

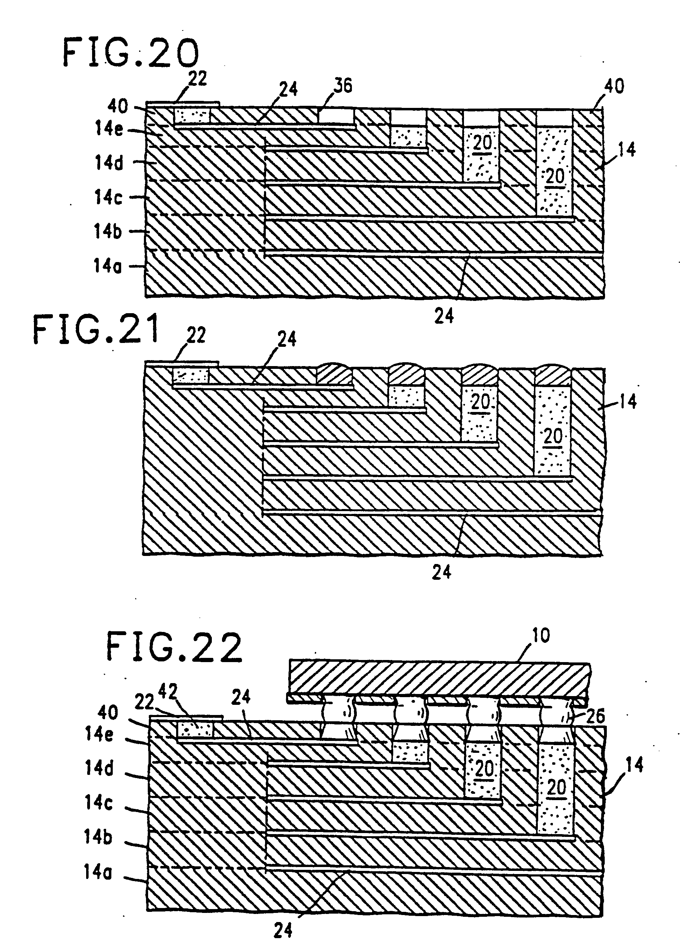

Figures 16 to 21 illustrate a further specific application of the generic invention in which a multi-layered ceramic substrate is provided with a unique structure for supporting C-4 columns in a recessed solder dam. As shown in Figure 16, a multi-layer ceramic substrate comprises a plurality of layers 14a-14e which are assembled and fired to provide a unitary substrate. U.S. Patent Nos. 4,245,273, previously mentioned, for example, discloses prior art processes for manufacturing such multi-layered ceramic substrates. In accordance with the embodiment of the invention illustrated in Figures 16 to 21, the final layer 40 of green, unsintered, ceramic is prepunched to provide a plurality of vias 36 positioned to be congruent with pads 16 and conductive paths 20, plus other vias 42 positioned to be congruent with conductive paths 22 and connection pads 18, for example. See Figure 17. A suitable mask 44 is provided having openings 46 therein which register with vias 36, mask 44 being blank at the location of vias 42. Vias 36 are filled with a combustible substance 48 such as terephthalic acid paste. See Figure 18. Then, a further mask 50 is provided having apertures 52 which register with vias 42, mask 50 being blank at the locations of vias 36. Vias 42 are then filled with a conductive material such as molybdenum paste. See Figure 19. Conductive paths 22 also may be screened onto the surface of layer 40 to provide a connection to pads 18, in the familiar manner. Then, layer 40 is laminated to the previously assembled stack of layers 14a-14e and fired to produce the structure in Figure 20, where combustible substance 48 has burned away to leave vias 36 open for receiving molten solder. Nickel and gold are plated onto the bottom surface of vias 36 to coat the exposed molybdenum of conductive paths 20 after which solder balls are set into vias 36 and reflowed to fill the vias as shown in Figure 21. Alternatively, the vias 36 may be filled with solder with ultrasonic dipping in a solder bath, solder lamination or evaporating solder into the vias and reflowing. A temporary protective coating may be used on other surfaces of substrate 14 to avoid solder contamination. Finally, a chip 10 with standard C-4 solder balls on its lower surface is placed in contact with substrate 14 so that the solder balls contact the solder in vias 36 ; the solder is reflowed and the elongated C-4 columns shown in Figure 16 are produced.

It is also within the scope of the invention to produce the empty vias 36 in top layer 40 by an embossing technique in which the upper ends of conductive paths 20 are forced downwardly by a suitably configured die to produce a recess having a depth of 0.025 to 0.125 mm. In some applications, it may also be desirable to provide C-4 columns with solder dams only around the periphery of the matrix of connections and conventional connections at the centre of the matrix, where the shear strains are much less than at the periphery.

In currently accepted designs for reliable C-4 solder columns, an approximately 17 by 17 matrix of 0.127 mm C-4 balls can be used on 0.254 mm centres. Using the structure illustrated in Figure 16, a matrix of 0.127 mm deep recesses can be used to support a 42 by 42 matrix of C-4 columns at fatigue strain levels which are currently acceptable.

If conventional 0.127 mm solder balls are joined to 0.127 mm deep columns in vias 36, on 0.254 mm centre, as shown in Figure 10, volume contraction in the solder and differential thermal shrinkage between the reflow temperature of about 300 degrees Celsius and a typical operating temperature of about 85 degrees Celsius can be shown to result in a combined differential shrinkage $\frac{\Delta\Lambda}{L}$ of about 0.0156. For vias 36 0.127 mm in radius, this will produce a gap $\Delta$, as in Figure 9, of about $99 \times 10^{-5}$ mm between the via and the C-4 column at operating temperature. As in Figure 12, the outside C-4 columns will be distorted to extreme positions at room temperature, and could actually contact the opposite walls of their vias.

To ensure that the outside C-4 columns do not undergo excessive shear strain and do not contact the opposite walls of their vias, the condition of Equations (8), (9) and (10) must be satisfied for the embodiment of Figure 16. In such a case, if $\gamma_m$ equals 0.0094, $\alpha_b$ equals $6.5 \times 10^{-6}$/degree K, and $\alpha_c$ equals $2.5 \times 10^{-6}$/degree K, then $\delta$, the maximum lateral displacement of a C-4 column, will be about $180 \times 10^{-5}$ mm. Since L in Equation (10) is equal to (n-1)a where n is the maximum number of columns on a side of the matrix of columns and a is the centre-to-centre spacing, the maximum number of columns on a side can be shown to be about 42 in accordance with the invention, compared to 17 with the prior art. The extreme C-4 columns will not deflect into contact with the opposite walls of their vias.

Figure 22 shows a fragmentary sectional view of still another specific application of the generic invention in which substrate 14 has been provided with recesses for solder of the type shown in Figures 16 to 21, while chip 10 also has been provided with recesses for solder of the type shown in Figure 3. It is within the scope of the invention to provide such recesses for all or only a selected portion of the connection points on either or both of chip 10 and substrate 14.

## Claims

1. A method for providing controlled collapse connections between a microelectronic chip (10) having a surface including a matrix of electrical connection points and a support substrate (14) having a surface including a corresponding matrix of electrical connection points (16), the method comprising the steps of :
   forming, from an electrically insulating material, at at least a portion of the connection points on at least one of said surfaces, dam means defining a central open volume around each such connection point;
   introducing molten solder into each open volume defined by the dam means ;
   allowing the solder to cool to form, at each of the connection points concerned, a solder column ;
   positioning the chip and the substrate such that the respective matrices of connection points are in alignment ;
   and heating the assembly thus formed to melt the solder columns and form said controlled collapse connections (26), the material of the dam means being such that, on subsequent cooling, the dam means and solder columns separate at least partially from each other so as to permit flexing of the solder columns.

2. A method as claimed in claim 1, in which the step of forming the dam means comprises :
   providing a layer of electrically insulating material on the respective surface ;
   and providing through the layer a plurality of holes corresponding to the connection points on each surface to be dammed, to thereby define the central open volume (36) at each such connection point.

3. A method as claimed in claim 2, in which the dam means are further defined by removing sections of the electrically insulating layer to leave an annular solder dam (32) surrounding each said open volume.

4. A method as claimed in any preceding claim in which the coefficient of thermal expansion of the damming material is about one fourth that of the solder.

5. A method as claimed in claim 2 or claim 4 in which the layer of electrically insulating material is ceramic.

6. A method as claimed in claim 5, in which the thickness of the damming layer is in the range 0.025 to 0.127 millimetres.

7. A method as claimed in claim 1, 2 or 3 in which the coefficient of thermal expansion of the damming material is substantially greater than that of the substrate or chip or both to which it is applied.

8. A method as claimed in claim 7, in which the damming material is a polyimide material.

9. A method as claimed in claim 7 or claim 8 in which the thickness of the damming layer is in the range 0.050 to 0.200 millimetres.

10. A method as claimed in any preceding claim in which the dam means and solder columns are formed on the substrate (14).

## Ansprüche

1. Verfahren für die Erzeugung kontrollierter Zusammenbruchanschlüsse zwischen einem Mikroelektronik-Chip (10) mit einer Oberfläche, die eine Matrix elektrischer Anschlußpunkte und ein Halterungssubstrat (14) enthält, das eine Oberfläche mit einer entsprechenden Matrix elektrischer Anschlußpunkte (16) aufweist, wobei das Verfahren folgende Schritte enthält :
   Bildung aus einem elektrisch isolierenden Material an mindestens einem Teil der Anschlußpunkte auf mindestens einer der besagten Flächen von Damm-Mitteln, die ein zentrales offenes Volumen um jeden dieser Anschlußpunkte festlegen ;

Einführung geschmolzener Lötmasse in jedes durch die Dammittel definierte offene Volumen ;

Warten bis zum Abkühlen der Lötmasse, so daß sie an jedem der betroffenen Anschlußpunkte eine Lötmassensäule bildet ;

Positionierung des Chips und des Substrats, so daß die jeweiligen Matrizen der Verbindungspunkte ausgerichtet sind ;

Erwärmung der so gebildeten Montage, um die Lötmassensäulen zu schmelzen und die besagten kontrollierten Zusammenbruchverbindungen (26) zu bilden, wobei der Werkstoff der Dammittel so gewählt wird, daß bei der anschließenden Kühlung die Dammittel und die Lötmassensäulen sich mindestens teilweise von einander trennen, um ein Biegen der Lötmassensäulen zu gestatten.

2. Verfahren gemäß Anspruch 1, in dem der Schritt der Bildung der Dammittel umfaßt :

Bereitstellung einer Schicht elektrisch isolierenden Materials auf den jeweiligen Flächen ;

und Bereitstellung, durch die Schicht, einer Mehrzahl von Löchern, die den Verbindungspunkten auf jeder Fläche entsprechen, die zu verschließen sind, um auf diese Weise das mittlere offene Volumen (36) an jedem solchen Verbindungspunkt zu bestimmen.

3. Verfahren gemäß Anspruch 2, in dem die Dammittel ferner durch Entfernen von Teilen der elektrisch isolierenden Schicht festgelegt werden, um einen ringförmigen Lötgutdamm (32) zu bilden, der jedes besagte offene Volumen umgibt.

4. Verfahren gemäß einem der vorangehenden Ansprüche, in dem der Wärmedehnungsbeiwert des Dämmaterials ca. ein Viertel dessen der Lötmasse beträgt.

5. Verfahren gemäß Anspruch 2 oder Anspruch 4, in dem die Schicht elektrisch isolierenden Materials Keramik ist.

6. Verfahren gemäß Anspruch 5, in dem die Dicke der Dämmschicht im Bereich von 0,025 bis 0,127 Millimeter liegt.

7. Verfahren gemäß Anspruch 1, 2 oder 3, in dem der Wärmedehnungsbeiwert des Däterials wesentlich größer ist als der des Substrats oder Chips, oder beider, auf die es aufgetraten wird.

8. Verfahren gemäß Anspruch 7, in dem das Dämmaterial ein Werkstoff aus Polyimid ist.

9. Verfahren gemäß Anspruch 7 oder Anspruch 8, in dem die Dicke der Dämmschicht im Bereich von 0,050 bis 0,200 Millimeter liegt.

10. Verfahren gemäß einem der vorangehenden Ansprüche, in dem das Dämmittel und die Lötmassensäulen auf dem Substrat (14) gebildet werden.


## Revendications

1. Procédé pour réaliser des connexions, pouvant être rompues sous des conditions de charge contrôlées, entre une puce microélectronique (10) ayant une surface présentant une matrice de points de connexion électrique et un substrat de support (14) ayant une surface présentant une matrice correspondante de points de connexion électrique (16), procédé qui comprend les étapes consistant à :

former, d'un matériau électriquement isolant, à au moins une partie des points de connexion, sur au moins l'une desdites surfaces, des moyens de barrage définissant un volume central ouvert autour de chacun de ces points de connexion ;

introduire de la soudure fondue dans chaque volume ouvert défini par les moyens de barrage ;

permettre à la soudure de se refroidir de manière à former une colonne de soudure à chacun des points de connexion concernés ;

positionner la puce et le substrat de manière que les matrices respectives de points de connexion soient alignées ;

et chauffer l'ensemble ainsi obtenue pour faire fondre les colonnes de soudure et établir lesdites connexions (26) à rupture contrôlée, le matériau des moyens de barrage étant tel que, lors du refroidissement consécutif, les moyens de barrage et les colonnes de soudure s'écartent au moins partiellement les uns des autres, de manière à permettre le fléchissement des colonnes de soudure.

2. Procédé selon la revendication 1, dans lequel l'étape consistant à former les moyens de barrage comprend :

l'application d'une couche de matériau électriquement isolant sur la surface concernée ; et

la réalisation, au travers de la couche d'une pluralité de trous correspondant aux points de connexion sur chaque surface à munir de moyens de barrage, de manière à définir ainsi le volume central ouvert (36) à chacun des points de connexion.

3. Procédé selon la revendication 2, dans lequel les moyens de barrage sont définis en plus par l'enlèvement de portions de la couche électriquement isolante, de manière à laisser subsister un barrage annulaire (32) de retenue de la soudure autour de chaque volume ouvert.

4. Procédé selon l'une quelconque des revendications précédentes, dans lequel le coefficient de dilatation thermique du matériau de barrage correspond à environ un quart de celui de la soudure.

5. Procédé selon la revendication 2 ou 4, dans lequel la couche de matériau électriquement isolant est de la céramique.

6. Procédé selon la revendication 5, dans lequel l'épaisseur de la couche de barrage est compris dans la gamme de 0,025 à 0,127 mm.

7. Procédé selon la revendication 1, 2 ou 3, dans lequel le coefficient de dilatation thermique du matériau de barrage est nettement plus grand que celui du substrat ou celui de la puce auquel ou à laquelle il est appliqué, ou des deux.

8. Procédé selon la revendication 7, dans lequel le matériau de barrage est un polyimide.

9. Procédé selon la revendication 7 ou 8, dans lequel l'épaisseur de la couche de barrage est comprise dans la gamme de 0,050 à 0,0200 mm.

10. Procédé selon l'une quelconque des revendications précédentes, dans lequel les moyens de barrage et les colonnes de soudure sont formés sur le substrat (14).

FIG. 1
PRIOR ART

FIG. 2
PRIOR ART

FIG. 3

FIG. 4

FIG. 5

FIG. 6

FIG. 7

FIG. 8

FIG. 9

CHIP CENTER

FIG. 11

FIG. 13

FIG. 15

(AT REFLOW TEMP.)

(AT ROOM TEMP.)

(AT OPERATING TEMP.)

CHIP EDGE

FIG. 10

FIG. 12

FIG. 14

FIG.16

FIG.17

FIG.18

FIG.19

## FIG.20

## FIG.21

## FIG.22